# EUROPEAN PATENT APPLICATION

(11) **EP 4 095 912 A1**
(43) Date of publication of application: **30.11.2022**
(21) Application number: 21744340.7
(22) Date of filing: 13.01.2021
(51) Int. Cl.: H01L 27/146, H04N 5/369

(54) **LIGHT RECEIVING ELEMENT, IMAGING ELEMENT, AND IMAGING DEVICE**

(30) Priority: 20.01.2020 JP 2020006566
(71) Applicant: Sony Semiconductor Solutions Corporation, Atsugi-shi Kanagawa 243-0014 (JP)
(72) Inventor: IMOTO, Tsutomu, Atsugi-shi, Kanagawa 243-0014 (JP)
(74) Representative: Müller Hoffmann & Partner
(86) International application number: PCT/JP2021/000839
(87) International publication number: WO 2021/149556

(57) **Abstract**

A light receiving element according to the present disclosure includes a sensor substrate (102) and a circuit board (101). The sensor substrate (102) is provided with a light receiving region (103), a pair of voltage application electrodes, and an incident surface electrode (104). The light receiving region (103) photoelectrically converts incident light into signal charges. A voltage is alternately applied to the pair of voltage application electrodes to generate, in the light receiving region (103), an electric field that time-divides the signal charges and distributes the signal charges to a pair of charge accumulation electrodes. The incident surface electrode (104) is provided on an incident surface of light in the light receiving region (103), and a voltage equal to or lower than a ground potential is applied to the incident surface electrode. The circuit board (101) is provided on a surface facing the incident surface of the light, of the sensor substrate (102). The circuit board (101) is provided with a pixel transistor that processes the signal charges accumulated in the charge accumulation electrodes.

## Description

### TECHNICAL FIELD

The present disclosure relates to a light receiving element, an imaging element, and an imaging device.

### BACKGROUND ART

A light receiving element to be used in a distance measuring system using an indirect time of flight (ToF) method includes a pixel array in which a plurality of light receiving pixels is arranged in a matrix. Each light receiving pixel includes a light receiving region that photoelectrically converts incident light into signal charges, and a pair of electrodes to which a voltage is alternately applied to generate in the light receiving region, an electric field that time-divides the signal charges and distributes the signal charges to a pair of charge accumulation electrodes. (See, for example, Patent Document 1).

### CITATION LIST

### PATENT DOCUMENT

Patent Document 1: Japanese Patent Application Laid-Open No. 2011-86904

### SUMMARY OF THE INVENTION

### PROBLEMS TO BE SOLVED BY THE INVENTION

However, as the light receiving pixel becomes finer, charge collection efficiency decreases.

The present disclosure therefore proposes a light receiving element, an imaging element, and an imaging device capable of increasing charge collection efficiency.

### SOLUTIONS TO PROBLEMS

According to the present disclosure, a light receiving element is provided. The light receiving element includes a sensor substrate and a circuit board. The sensor substrate is provided with a light receiving region, a pair of voltage application electrodes, and an incident surface electrode. The light receiving region photoelectrically converts incident light into signal charges. To the pair of voltage application electrodes, a voltage is alternately applied to generate in the light receiving region, an electric field that time-divides the signal charges and distributes the signal charges to a pair of charge accumulation electrodes. The incident surface electrode is provided on an incident surface of light in the light receiving region, and a voltage equal to or lower than a ground potential is applied to the incident surface electrode. The circuit board is provided on a surface facing the incident surface of the light, of the sensor substrate. The circuit board is provided with a pixel transistor that processes the signal charges accumulated in the charge accumulation electrodes.

### BRIEF DESCRIPTION OF THE DRAWINGS

Fig. 1 is a diagram illustrating a configuration example of a solid-state imaging element which is an example of a light receiving element according to the present disclosure.
Fig. 2 is a diagram illustrating a configuration example of a pixel according to the present disclosure.
Fig. 3 is a diagram illustrating a configuration example of a portion of a signal retrieval portion of the pixel according to the present disclosure.
Fig. 4 is a diagram illustrating a circuit configuration example of the pixel according to the present disclosure.
Fig. 5 is a diagram illustrating a connection mode between a circuit board and a sensor substrate according to the present disclosure.
Fig. 6 is an explanatory diagram of an incident surface electrode and a pixel separation region according to the present disclosure.
Fig. 7A is a diagram illustrating a configuration example of the pixel separation region according to the present disclosure.
Fig. 7B is a diagram illustrating a configuration example of the pixel separation region according to the present disclosure.
Fig. 7C is a diagram illustrating a configuration example of the pixel separation region according to the present disclosure.
Fig. 8 is an explanatory diagram of a pixel separation region according to a first modification of the present disclosure.
Fig. 9 is an explanatory diagram of a pixel separation region according to a second modification of the present disclosure.
Fig. 10 is a diagram illustrating an arrangement example of the pixel separation region according to the present disclosure.

### MODE FOR CARRYING OUT THE INVENTION

Hereinafter, embodiments of the present disclosure will be described in detail on the basis of the drawings. Note that in each of the following embodiments, the same parts are denoted by the same reference numerals, and redundant description will be omitted.

### [1. Configuration Example of Solid-state Imaging Element]

The present technology can be applied to, for example, a solid-state imaging element constituting a distance measuring system that performs distance measurement using an indirect time of flight (ToF) method, an imaging device including such a solid-state imaging element, and the like.

For example, the distance measuring system can be applied to an in-vehicle system that is mounted on a vehicle and measures a distance to an object outside the vehicle, a gesture recognition system that measures a distance to an object such as the hand of a user and recognizes a gesture of the user on the basis of a measurement result, and the like.

In this case, the result of the gesture recognition can be used for, for example, operation of a car navigation system, or the like.

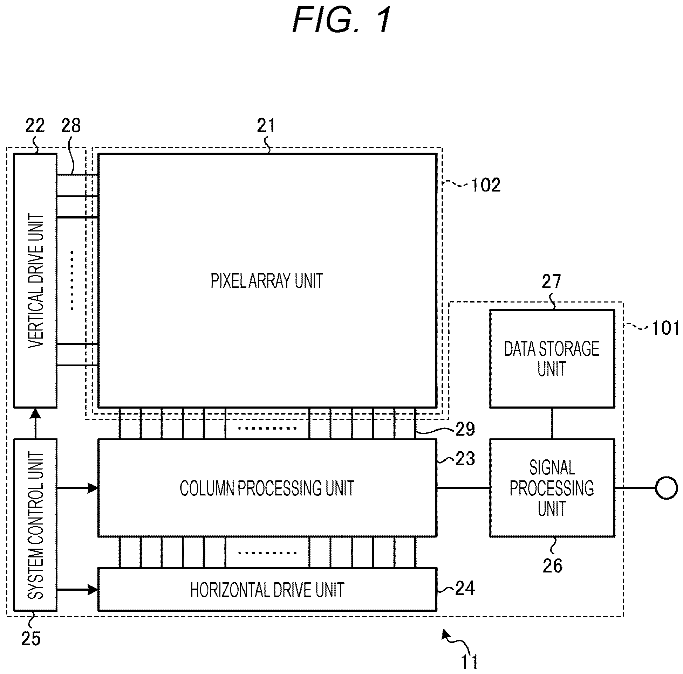

Fig. 1 is a diagram illustrating a configuration example of a solid-state imaging element which is an example of a light receiving element according to the present disclosure. A solid-state imaging element 11 illustrated in Fig. 1 is a back-illuminated current assisted photonic demodulator (CAPD) sensor and is provided in an imaging device having a distance measuring function.

The solid-state imaging element 11 includes a circuit board 101 and a sensor substrate 102 stacked on the circuit board 101. The sensor substrate 102 is provided with a pixel array unit 21 in which a plurality of light receiving pixels (hereinafter, simply referred to as "pixels") is arranged in a matrix.

The circuit board 101 is provided with a peripheral circuit. The peripheral circuit unit is provided with, for example, a vertical drive unit 22, a column processing unit 23, a horizontal drive unit 24, a system control unit 25, and the like. The vertical drive unit 22 includes, for example, a pixel transistor, or the like, that processes signal charges photoelectrically converted at each pixel. Note that, here, in order to facilitate understanding of a connection relationship between components of the circuit board 101 and components of the sensor substrate 102, the components are illustrated on the same plane.

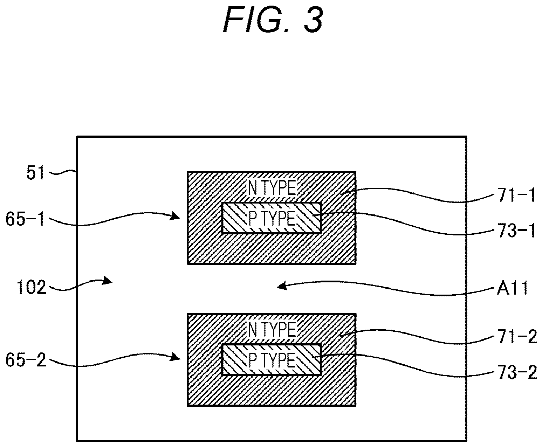

As described above, in the solid-state imaging element 11, the pixels of the pixel array unit 21 are provided on the sensor substrate 102, and the pixel transistor is provided on the circuit board 101, whereby charge collection efficiency can be improved and power consumption can be reduced. Such a point will be described later with reference to Fig. 3.

The solid-state imaging element 11 is further provided with a signal processing unit 26 and a data storage unit 27. Note that the signal processing unit 26 and the data storage unit 27 may be mounted on the same substrate as the solid-state imaging element 11 or may be arranged on a substrate different from the solid-state imaging element 11 in the imaging device.

The pixel array unit 21 has a configuration in which pixels that generate charges according to an amount of received light and output signals according to the charges are arranged in two dimensions in a row direction and in a column direction, that is, in a matrix. In other words, the pixel array unit 21 includes a plurality of pixels that photoelectrically converts incident light and outputs signals corresponding to charges obtained as a result.

Here, the row direction refers to an arrangement direction of pixels in a pixel row (that is, in a horizontal direction), and the column direction refers to an arrangement direction of pixels in a pixel column (that is, in a vertical direction). In other words, the row direction is the horizontal direction in the drawing, and the column direction is the vertical direction in the drawing.

In the pixel array unit 21, a pixel drive line 28 is wired along the row direction for each pixel row, and two vertical signal lines 29 are wired along the column direction for each pixel column with respect to the pixel array in the matrix. For example, the pixel drive line 28 transmits a drive signal for performing driving when a signal is read out from a pixel. Note that, in Fig. 1, the pixel drive line 28 is illustrated as one wiring, but the pixel drive line 28 is not limited to one. One end of the pixel drive line 28 is connected to an output end corresponding to each row of the vertical drive unit 22.

The vertical drive unit 22 includes a shift register, an address decoder, and the like, and drives all the pixels of the pixel array unit 21 at the same time or in units of rows. In other words, the vertical drive unit 22 constitutes a drive unit that controls operation of each pixel of the pixel array unit 21 together with the system control unit 25 that controls the vertical drive unit 22.

A signal output from each pixel of the pixel row according to drive control by the vertical drive unit 22 is input to the column processing unit 23 through the vertical signal line 29. The column processing unit 23 performs predetermined signal processing on a signal output from each pixel through the vertical signal line 29 and temporarily stores a pixel signal after the signal processing.

Specifically, the column processing unit 23 performs noise removal processing, analog to digital (AD) conversion processing, and the like, as the signal processing.

The horizontal drive unit 24 includes a shift register, an address decoder, and the like, and sequentially selects unit circuits corresponding to pixel columns of the column processing unit 23. By selective scanning by the horizontal drive unit 24, the pixel signals subjected to the signal processing for each unit circuit in the column processing unit 23 are sequentially output.

The system control unit 25 includes a timing generator that generates various timing signals, and the like, and performs drive control of the vertical drive unit 22, the column processing unit 23, the horizontal drive unit 24, and the like, on the basis of the various timing signals generated by the timing generator.

The signal processing unit 26 has at least an arithmetic processing function and performs various kinds of signal processing such as arithmetic processing on the basis of the pixel signals output from the column processing unit 23. The data storage unit 27 temporarily stores data necessary for the signal processing in the signal processing unit 26.

### [2. Configuration Example of Pixel]

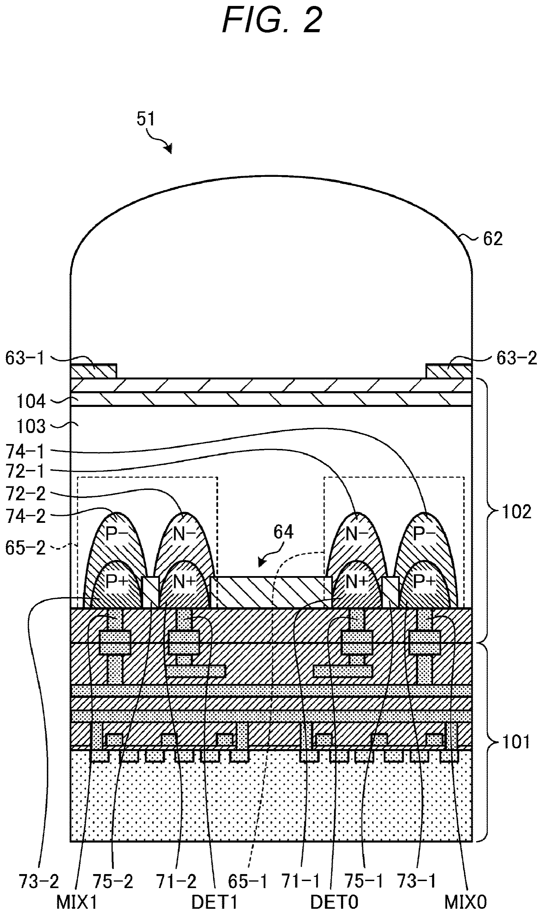

Next, a configuration example of the pixel provided in the pixel array unit 21 will be described. The pixel provided in the pixel array unit 21 is configured as illustrated in Fig. 2, for example.

Fig. 2 illustrates a cross section of one pixel 51 provided in the pixel array unit 21, and this pixel 51 receives and photoelectrically converts light, in particular, infrared light, incident on the light receiving region 103 from outside and outputs signals corresponding to charges obtained as a result.

The pixel 51 includes, for example, a silicon substrate, that is, a sensor substrate 102 including a P-type semiconductor substrate including a P-type semiconductor region, and an on-chip lens 62 which is an example of an imaging optical system formed on the sensor substrate 102. The sensor substrate 102 is stacked on the circuit board 101.

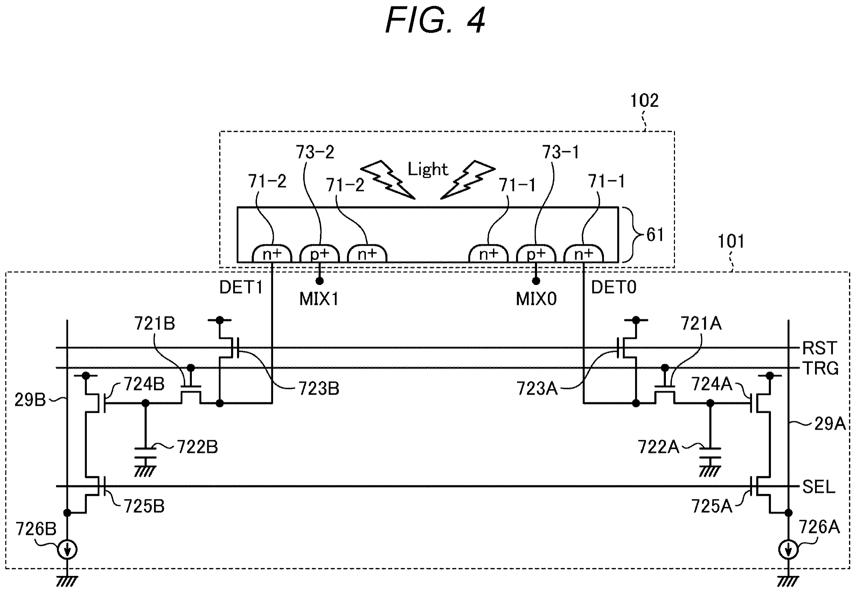

The circuit board 101 is provided with a pixel transistor such as a transfer transistor, a reset transistor, an amplification transistor, and a selection transistor which will be described later. An example of a circuit configuration of the circuit board 101 will be described later with reference to Fig. 4.

In the drawing, on an upper surface of the sensor substrate 102, that is, on a surface on a side on which light is incident from outside, of the light receiving region 103 (hereinafter, also referred to as an incident surface), an on-chip lens 62 that collects light incident from the outside and causes the light to be incident within the light receiving region 103 is formed.

Further, in the pixel 51, an inter-pixel light shielding portion 63-1 and an inter-pixel light shielding portion 63-2 for preventing color mixture between adjacent pixels are formed at end portions of the pixel 51 on the incident surface of the light receiving region 103.

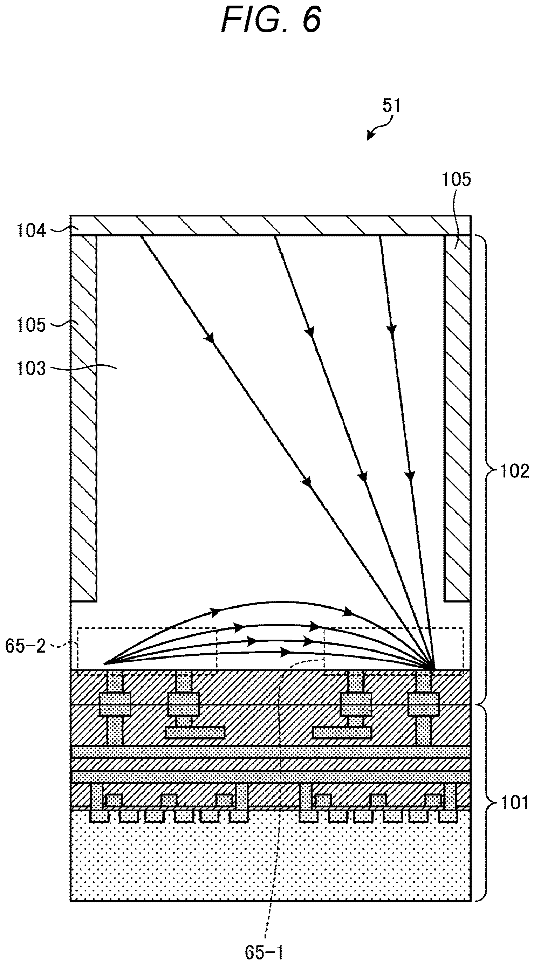

Still further, in the sensor substrate 102, the incident surface electrode 104 to which a voltage equal to or lower than the ground potential is applied is provided on the incident surface in the light receiving region 103, whereby the charge collection efficiency can be improved. Such a point will be described later with reference to Fig. 6.

An oxide film 64, and a signal retrieval portion 65-1 and a signal retrieval portion 65-2 called Tap (tap) are formed on a surface side opposite to the incident surface in the light receiving region 103, that is, at portions inside a surface of a lower portion in the drawing.

In this example, the oxide film 64 is formed at the center portion of the pixel 51 in the vicinity of the surface of the light receiving region 103 opposite to the incident surface, and the signal retrieval portion 65-1 and the signal retrieval portion 65-2 are respectively formed at both ends of the oxide film 64.

Here, the signal retrieval portion 65-1 includes an N+ semiconductor region 71-1 and an N- semiconductor region 72-1 which are N type semiconductor regions, and a P+ semiconductor region 73-1 and a P- semiconductor region 74-1 which are P type semiconductor regions.

In other words, the N+ semiconductor region 71-1 is formed at a portion adjacent to the right side of the oxide film 64 in the drawing at a portion inside the surface on the opposite side to the incident surface of the light receiving region 103. Further, the N- semiconductor region 72-1 is formed on the upper side of the N+ semiconductor region 71-1 in the drawing so as to cover (surround) the N+ semiconductor region 71-1.

Still further, the P+ semiconductor region 73-1 is formed at a portion adjacent to the right side in the drawing of the N+ semiconductor region 71-1 at a portion inside the surface on the opposite side of the incident surface of the light receiving region 103. Furthermore, the P- semiconductor region 74-1 is formed on the upper side of the P+ semiconductor region 73-1 in the drawing so as to cover (surround) the P+ semiconductor region 73-1.

Note that, although not illustrated here, more specifically, when the light receiving region 103 is viewed from a direction perpendicular to the surface of the sensor substrate 102, the N+ semiconductor region 71-1 and the N-semiconductor region 72-1 are formed so as to surround the P+ semiconductor region 73-1 and the P- semiconductor region 74-1 around the P+ semiconductor region 73-1 and the P-semiconductor region 74-1.

Similarly, the signal retrieval portion 65-2 includes an N- semiconductor region 72-2 having concentration of donor impurity lower than that of the N+ semiconductor region 71-2 and the N+ semiconductor region 71-2, which are N type semiconductor regions, and a P- semiconductor region 74-2 having concentration of acceptor impurity lower than that of the P+ semiconductor region 73-2 and the P+ semiconductor region 73-2, which are P type semiconductor regions. Here, examples of the donor impurity include elements belonging to Group 5 in the periodic table of elements such as phosphorus (P) and arsenic (As) with respect to Si. Examples of the acceptor impurity include elements belonging to Group 3 in the periodic table of elements such as boron (B) with respect to Si.

In other words, the N+ semiconductor region 71-2 is formed at a position adjacent to the left side of the oxide film 64 in the drawing at a portion inside the surface on the opposite side of the incident surface of the light receiving region 103. Further, the N- semiconductor region 72-2 is formed on the upper side of the N+ semiconductor region 71-2 in the drawing so as to cover (surround) the N+ semiconductor region 71-2.

Still further, the P+ semiconductor region 73-2 is formed at a position adjacent to the left side in the drawing of the N+ semiconductor region 71-2 at a portion inside the surface on the opposite side of the incident surface of the light receiving region 103. Furthermore, the P- semiconductor region 74-2 is formed on the upper side of the P+ semiconductor region 73-2 in the drawing so as to cover (surround) the P+ semiconductor region 73-2.

Note that, although not illustrated here, more specifically, when the light receiving region 103 is viewed from a direction perpendicular to the surface of the sensor substrate 102, the N+ semiconductor region 71-2 and the N-semiconductor region 72-2 are formed so as to surround the P+ semiconductor region 73-2 and the P- semiconductor region 74-2 around the P+ semiconductor region 73-2 and the P-semiconductor region 74-2.

Hereinafter, the signal retrieval portion 65-1 and the signal retrieval portion 65-2 will also be simply referred to as a signal retrieval portion 65 in a case where it is not particularly necessary to distinguish them.

In addition, hereinafter, the N+ semiconductor region 71-1 and the N+ semiconductor region 71-2 will be also simply referred to as the N+ semiconductor region 71 in a case where it is not particularly necessary to distinguish them, and the N- semiconductor region 72-1 and the N- semiconductor region 72-2 will be also simply referred to as the N- semiconductor region 72 in a case where it is not particularly necessary to distinguish them.

Furthermore, hereinafter, the P+ semiconductor region 73-1 and the P+ semiconductor region 73-2 will be also simply referred to as a P+ semiconductor region 73 in a case where it is not particularly necessary to distinguish them, and the P-semiconductor region 74-1 and the P- semiconductor region 74-2 will be also simply referred to as a P- semiconductor region 74 in a case where it is not particularly necessary to distinguish them.

Furthermore, in the light receiving region 103, an isolation portion 75-1 for isolating the N+ semiconductor region 71-1 and the P+ semiconductor region 73-1 from each other is formed between the regions with an oxide film, or the like. Similarly, an isolation portion 75-2 for isolating the N+ semiconductor region 71-2 and the P+ semiconductor region 73-2 from each other is also formed between these regions with an oxide film, or the like. Hereinafter, the isolation portion 75-1 and the isolation portion 75-2 will also be simply referred to as an isolation portion 75 in a case where it is not particularly necessary to distinguish them.

The N+ semiconductor region 71 provided in the light receiving region 103 functions as a detection unit for detecting the amount of light incident on the pixel 51 from outside, that is, an amount of signal carriers generated through photoelectric conversion by the light receiving region 103. In addition, the P+ semiconductor region 73 functions as an injection contact portion for injecting a majority carrier current into the light receiving region 103, that is, for generating an electric field in the light receiving region 103 by directly applying a voltage to the light receiving region 103.

In the pixel 51, a floating diffusion (FD) portion (hereinafter, also particularly referred to as an FD portion A) which is a floating diffusion region not illustrated is directly connected to the N+ semiconductor region 71-1, and the FD portion A is further connected to the vertical signal line 29 via an amplification transistor, or the like, which is not illustrated.

Similarly, another FD portion (hereinafter, also particularly referred to as an FD portion B) different from the FD portion A is directly connected to the N+ semiconductor region 71-2, and the FD portion B is further connected to the vertical signal line 29 via an amplification transistor, or the like, which is not illustrated. Here, the FD portion A and the FD portion B are connected to different vertical signal lines 29.

For example, in a case where a distance to the object is to be measured using the indirect ToF method, infrared light is emitted from the imaging device provided with the solid-state imaging element 11 toward the object. Then, when the infrared light is reflected by the object and returns to the imaging device as reflected light, the light receiving region 103 of the solid-state imaging element 11 receives and photoelectrically converts the incident reflected light (infrared light).

In this event, the vertical drive unit 22 drives the pixel 51 and distributes signals corresponding to the electric charges obtained by photoelectric conversion to the FD portion A and the FD portion B. Note that, as described above, the pixel 51 may be driven not by the vertical drive unit 22 but by a separately provided drive unit, the horizontal drive unit 24, or the like, via the vertical signal line 29 or another control line elongated in the vertical direction.

For example, at a certain timing, the vertical drive unit 22 applies a voltage to the two P+ semiconductor regions 73 via contacts, or the like. Specifically, for example, the vertical drive unit 22 applies a voltage of 1.5 V to the P+ semiconductor region 73-1 and applies a voltage of 0 V to the P+ semiconductor region 73-2.

Then, an electric field is generated between the two P+ semiconductor regions 73 in the light receiving region 103, and a current flows from the P+ semiconductor region 73-1 to the P+ semiconductor region 73-2. In this case, holes (holes) in the light receiving region 103 move in the direction of the P+ semiconductor region 73-2, and electrons move in the direction of the P+ semiconductor region 73-1.

Thus, in such a state, when infrared light (reflected light) from the outside is incident on the light receiving region 103 via the on-chip lens 62, and the infrared light is photoelectrically converted into pairs of electrons and holes in the light receiving region 103, the obtained electrons are guided in the direction of the P+ semiconductor region 73 by the electric field between the P+ semiconductor regions 73-1 and move into the N+ semiconductor region 71-1.

In this case, the electrons generated by photoelectric conversion are used as signal carriers for detecting a signal corresponding to the amount of infrared light incident on the pixel 51, that is, the amount of received infrared light.

As a result, in the N+ semiconductor region 71-1, charges according to the electrons moving into the N+ semiconductor region 71-1 are accumulated, and the charges are detected by the column processing unit 23 via the FD portion A, the amplification transistor, the vertical signal line 29, and the like.

In other words, the accumulated charges in the N+ semiconductor region 71-1 are transferred to the FD portion A directly connected to the N+ semiconductor region 71-1, and signals corresponding to the charges transferred to the FD portion A are read out by the column processing unit 23 via the amplification transistor and the vertical signal line 29. Then, processing such as AD conversion processing is performed on the read signals in the column processing unit 23, and pixel signals obtained as a result are supplied to the signal processing unit 26.

The pixel signals are signals indicating the amount of charges according to the electrons detected by the N+ semiconductor region 71-1, that is, the amount of charges accumulated in the FD portion A. In other words, it can also be said that the pixel signals are signals indicating the amount of infrared light received by the pixel 51.

Furthermore, at the next timing, a voltage is applied to the two P+ semiconductor regions 73 via contacts, or the like, by the vertical drive unit 22 so as to generate an electric field in a direction opposite to the electric field generated in the light receiving region 103 so far. Specifically, for example, a voltage of 1.5 V is applied to the P+ semiconductor region 73-2, and a voltage of 0 V is applied to the P+ semiconductor region 73-1.

As a result, an electric field is generated between the two P+ semiconductor regions 73 in the light receiving region 103, and a current flows from the P+ semiconductor region 73-2 to the P+ semiconductor region 73-1.

In such a state, when infrared light (reflected light) from the outside is incident in the light receiving region 103 via the on-chip lens 62 and the infrared light is photoelectrically converted into pairs of electrons and holes in the light receiving region 103, the obtained electrons are guided in the direction of the P+ semiconductor region 73 by the electric field between the P+ semiconductor regions 73-2 and move into the N+ semiconductor region 71-2.

As a result, in the N+ semiconductor region 71-2, charges according to the electrons moving into the N+ semiconductor region 71-2 are accumulated, and the charges are detected by the column processing unit 23 via the FD portion B, the amplification transistor, the vertical signal line 29, and the like.

In other words, the accumulated charges in the N+ semiconductor region 71-2 are transferred to the FD portion B directly connected to the N+ semiconductor region 71-2, and signals corresponding to the charges transferred to the FD portion B are read out by the column processing unit 23 via the amplification transistor and the vertical signal line 29. Then, processing such as AD conversion processing is performed on the read signals in the column processing unit 23, and pixel signals obtained as a result are supplied to the signal processing unit 26.

In this way, when pixel signals obtained by photoelectric conversion in different periods are obtained in the same pixel 51, the signal processing unit 26 calculates distance information indicating the distance to the object on the basis of these pixel signals and outputs the distance information to the subsequent stage.

A method of distributing the signal carriers to the N+ semiconductor regions 71 different from each other in this manner and calculating distance information on the basis of the signals corresponding to the signal carriers is called an indirect ToF method.

Furthermore, when a portion of the signal retrieval portion 65 in the pixel 51 is viewed from the top to the bottom in Fig. 2, that is, in a direction perpendicular to the surface of the light receiving region 103, for example, as illustrated in Fig. 3, the portion has a structure in which the P+ semiconductor region 73 is surrounded by the N+ semiconductor region 71. Note that, in Fig. 3, portions corresponding to those in Fig. 2 are denoted by the same reference numerals, and the description thereof will be omitted as appropriate.

In the example illustrated in Fig. 3, an oxide film 64 (not illustrated) is formed at the central portion of the pixel 51, and the signal retrieval portions 65 are formed at portions slightly closer to ends of the pixel 51 from the center. In particular, here, two signal retrieval portions 65 are formed in the pixel 51.

Then, in each signal retrieval portion 65, the P+ semiconductor region 73 is formed in a rectangular shape at the center position, and the P+ semiconductor region 73 is surrounded by the N+ semiconductor region 71 having a rectangular shape, more specifically, a rectangular frame shape, around the P+ semiconductor region 73. In other words, the N+ semiconductor region 71 is formed so as to surround the periphery of the P+ semiconductor region 73.

Furthermore, in the pixel 51, the on-chip lens 62 is formed so that infrared light incident from the outside is collected at the central portion of the pixel 51, that is, the portion indicated by an arrow A11. In other words, the infrared light incident on the on-chip lens 62 from the outside is collected by the on-chip lens 62 at the position indicated by the arrow A11, that is, the upper position in Fig. 2 of the oxide film 64 in Fig. 2.

Here, in a general pixel to be used for distance measurement of the indirect ToF method, the signal retrieval portion 65 and the pixel transistor are provided in the same layer in the sensor substrate 102. Thus, as the pixel becomes finer, a distance between the signal retrieval portion 65 and the pixel transistor becomes shorter, and current leakage occurs from the signal retrieval portion 65 to the pixel transistor side, which leads to decrease in the charge collection efficiency.

Specifically, as described above, the pixel alternately applies a predetermined voltage to the pair of P+ semiconductor regions 73, sequentially causes a bidirectional current to flow between the P+ semiconductor region 73-1 and the P+ semiconductor region 73-2, and distributes the charges obtained by photoelectric conversion to the FD portion A and the FD portion B.

However, when the pixel becomes finer and the distance between the signal retrieval portion 65 and the pixel transistor becomes shorter, part of the current that should originally flow between the P+ semiconductor region 73-1 and the P+ semiconductor region 73-2 leaks to a Pwell region of the pixel transistor.

As a result, not only power consumption of the pixel increases, but also intensity of an electric field that is generated in the light receiving region to guide the charges to the signal retrieval portion 65 decreases, which results in decrease in the charges to be captured by the N+ semiconductor region 71, leading to decrease in the charge collection efficiency.

Thus, in the pixel 51 according to the present disclosure, the pixel transistor is provided on the circuit board 101, and the light receiving region 103 including the signal retrieval portion 65 is provided on the sensor substrate 102 stacked on the circuit board 101.

As described above, in the pixel 51, the signal retrieval portion 65 and the pixel transistor are provided on different stacked substrates, and thus, even if the pixel 51 becomes finer in a plane direction, the distance between the signal retrieval portion 65 and the pixel transistor does not become shorter.

Thus, in a case where the pixel 51 becomes finer, it is possible to reduce power consumption and improve charge collection efficiency by preventing current leakage from the signal retrieval portion 65 to the pixel transistor.

### [3. Circuit Configuration Example of Pixel]

Next, a circuit configuration example of the pixel according to the present disclosure will be described with reference to Fig. 4. Fig. 4 is a diagram illustrating the circuit configuration example of the pixel according to the present disclosure.

As illustrated in Fig. 4, in the pixel 51, the signal retrieval portion 65-1 including the N+ semiconductor region 71-1, the P+ semiconductor region 73-1, and the like, is provided on the sensor substrate 102. The circuit board 101 is provided with a transfer transistor 721A, an FD 722A, a reset transistor 723A, an amplification transistor 724A, and a selection transistor 725A which are pixel transistors corresponding to the signal retrieval portion 65-1.

Furthermore, in the pixel 51, the signal retrieval portion 65-2 including the N+ semiconductor region 71-2, the P+ semiconductor region 73-2, and the like, is provided on the sensor substrate 102. The circuit board 101 is provided with a transfer transistor 721B, an FD 722B, a reset transistor 723B, an amplification transistor 724B, and a selection transistor 725B which are pixel transistors corresponding to the signal retrieval portion 65-2.

The vertical drive unit 22 applies a predetermined voltage MIX0 to the P+ semiconductor region 73-1 and applies a predetermined voltage MIX1 to the P+ semiconductor region 73-2. In the above-described example, one of the voltages MIX0 and MIX1 is 1.5 V and the other is 0 V. The P+ semiconductor regions 73-1 and 73-2 are voltage application electrodes to which a predetermined voltage is applied.

The N+ semiconductor regions 71-1 and 71-2 are charge accumulation electrodes that detect and accumulate charges generated by photoelectric conversion of light incident on the light receiving region 103.

When a drive signal TRG supplied to a gate electrode becomes an active state, the transfer transistor 721A becomes a conductive state in response to this, thereby transferring the charges accumulated in the N+ semiconductor region 71-1 to the FD 722A. When the drive signal TRG supplied to the gate electrode becomes the active state, the transfer transistor 721B becomes a conductive state in response to this, thereby transferring the charges accumulated in the N+ semiconductor region 71-2 to the FD 722B.

The FD 722A temporarily stores the charges supplied from the N+ semiconductor region 71-1. The FD 722B temporarily stores the charges supplied from the N+ semiconductor region 71-2. The FD 722A corresponds to the FD portion A described with reference to Fig. 2, and the FD 722B corresponds to the FD portion B.

When a drive signal RST supplied to the gate electrode becomes an active state, the reset transistor 723A becomes a conductive state in response to this, thereby resetting a potential of the FD 722A to a predetermined level (reset voltage VDD). When the drive signal RST supplied to the gate electrode becomes an active state, the reset transistor 723B becomes a conductive state in response to this, thereby resetting a potential of the FD 722B to a predetermined level (reset voltage VDD). Note that when the reset transistors 723A and 723B are put into an active state, the transfer transistors 721A and 721B are also put into an active state at the same time.

A source electrode of the amplification transistor 724A is connected to the vertical signal line 29A via the selection transistor 725A, thereby constituting a source follower circuit with a load MOS of a constant current source circuit unit 726A connected to one end of the vertical signal line 29A. The amplification transistor 724B has a source electrode connected to the vertical signal line 29B via the selection transistor 725B, thereby constituting a source follower circuit with a load MOS of a constant current source circuit unit 726B connected to one end of the vertical signal line 29B.

The selection transistor 725A is connected between a source electrode of the amplification transistor 724A and the vertical signal line 29A. When a selection signal SEL supplied to the gate electrode becomes an active state, the selection transistor 725A becomes a conductive state in response to this and outputs the pixel signals output from the amplification transistor 724A to the vertical signal line 29A.

The selection transistor 725B is connected between the source electrode of the amplification transistor 724B and the vertical signal line 29B. When the selection signal SEL supplied to the gate electrode becomes an active state, the selection transistor 725B becomes a conductive state in response to this and outputs the pixel signals output from the amplification transistor 724B to the vertical signal line 29B.

The transfer transistors 721A and 721B, the reset transistors 723A and 723B, the amplification transistors 724A and 724B, and the selection transistors 725A and 725B of the pixel 51 are controlled by, for example, the vertical drive unit 22.

As described above, in the pixel 51, the signal retrieval portion 65 is provided on the sensor substrate 102 and the pixel transistor is provided on the circuit board 101, which prevents leakage of a current from the signal retrieval portion 65 to the pixel transistor, so that the charge collection efficiency can be improved.

Furthermore, in the pixel 51, the light receiving region 103 including the signal retrieval portion 65 is formed with, for example, a III-V group semiconductor such as GaAs and InGaAs. As a result, the pixel 51 can improve quantum efficiency by a direct transition type band structure, improve sensitivity, and reduce a sensor height by thinning the substrate.

Furthermore, the light receiving region 103 including the signal retrieval portion 65 may be formed with, for example, Ge, GaSb, or the like. In this case, the pixel 51 can improve electron collection efficiency by high electron mobility and reduce power consumption by low hole mobility.

### [4. Connection Mode between Circuit Board and Sensor Substrate]

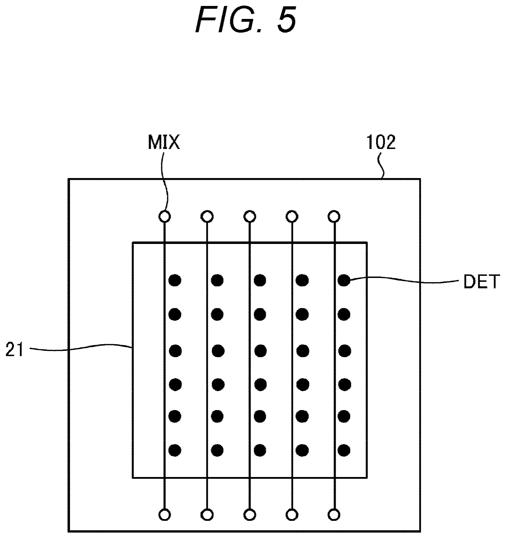

Next, a connection mode between the circuit board and the sensor substrate will be described with reference to Fig. 5. Fig. 5 is a diagram illustrating a connection mode between the circuit board and the sensor substrate according to the present disclosure.

Fig. 5 indicates with a white circle, a Cu-Cu joint MIX connecting the wiring on the sensor substrate 102 side that applies a predetermined voltage to the P+ semiconductor region 73 of the light receiving region 103 and the wiring on the circuit board 101 side. In addition, Fig. 5 indicates with a black circle, a Cu-Cu joint DET connecting the wiring on the sensor substrate 102 side connected to the N+ semiconductor region 71 of the light receiving region 103 and the wiring on the circuit board 101 side.

As illustrated in Fig. 5, in the pixel 51, the Cu-Cu joints MIX are provided at two locations outside the pixel array 21. Further, the Cu-Cu joints DET are provided at two locations for each pixel 51. By this means, the pixel 51 can be easily made finer by reducing the number of Cu-Cu joints MIX as compared with a case where the Cu-Cu joints MIX are provided for each pixel. It is noted that the Cu-Cu joint MIX may be constituted by a through chip via (TCV). In addition, the Cu-Cu joints MIX and DET may be constituted by bumps.

### [5. Incident Surface Electrode and Pixel Separation Region]

Next, an incident surface electrode and a pixel separation region according to the present disclosure will be described with reference to Fig. 6. Fig. 6 is an explanatory diagram of the incident surface electrode and the pixel separation region according to the present disclosure. As illustrated in Fig. 6, in the pixel 51, for example, when a current flows from the signal retrieval portion 65-1 to the signal retrieval portion 65-2 in the light receiving region 103, the photoelectrically converted charges are induced from the signal retrieval portion 65-2 to the signal retrieval portion 65-1 as indicated by an arrow by the electric field generated by the current.

Here, as the pixel 51 becomes finer in a plane direction of the light incident surface, an interval between the signal retrieval portion 65-1 and the signal retrieval portion 65-2 becomes shorter, but a length in a thickness (depth) direction of the light receiving region 103 does not become shorter.

Thus, in a case where the pixel 51 becomes finer, even if a current flows from the signal retrieval portion 65-1 to the signal retrieval portion 65-2, the electric field cannot be sufficiently expanded to the vicinity of the light incident surface in the light receiving region 103. As a result, the pixel 51 cannot efficiently guide the charges photoelectrically converted in the vicinity of the light incident surface in the light receiving region 103 to the signal retrieval portion 65-2, which leads to decrease in the charge collection efficiency.

Thus, in the pixel 51, the incident surface electrode 104 is provided on the light incident surface in the light receiving region 103. The incident surface electrode is connected to, for example, a ground (ground) wire or a negative voltage generation circuit provided on the circuit board 101, and 0 V or a negative voltage is applied thereto.

Thus, in the pixel 51, when a current flows from the signal retrieval portion 65-1 to the signal retrieval portion 65-2, a current also flows from the signal retrieval portion 65-1 to the incident surface electrode 104. As a result, the pixel 51 can efficiently guide the charges photoelectrically converted in the vicinity of the light incident surface to the signal retrieval portion 65-1 as indicated by an arrow by the electric field generated by the current flowing from the signal retrieval portion 65-2 to the incident surface electrode 104.

As described above, the pixel 51 includes the incident surface electrode 104 to which a voltage equal to or lower than the ground potential is applied on the light incident surface, and thus, even if the pixel becomes finer, the charge collection efficiency can be improved by guiding the charges photoelectrically converted in the vicinity of the light incident surface to the signal retrieval portion 65-1.

Note that the incident surface electrode 104 needs to transmit incident light, and thus, a transparent electrode is adopted. For example, the incident surface electrode 104 is, for example, a hole accumulation layer formed on the light incident surface by a negative fixed charge film laminated on the light incident surface in the light receiving region 103.

In addition, the incident surface electrode 104 may be a P-type conductive layer in which the light incident surface in the light receiving region 103 is doped with a P-type impurity. Further, the incident surface electrode 104 may be an
inorganic electrode film such as an indium tin oxide (ITO) film laminated on the light incident surface in the light receiving region 103. In addition, the incident surface electrode 104 may be a metal film such as a W film having a film thickness (for example, equal to or less than 50 nm) having translucency and laminated on the light incident surface in the light receiving region 103.

In a case where any of the above-described incident surface electrodes 104 is provided, the pixel 51 can efficiently guide the charges photoelectrically converted in the vicinity of the light incident surface to the signal retrieval portion 65 by the electric field generated by the current flowing from the signal retrieval portion 65 to the incident surface electrode 104.

Furthermore, the pixel 51 includes a pixel separation region 105 electrically separating the adjacent light receiving regions between the light receiving region 103 and the light receiving region 103 of the adjacent pixel 51. The pixel separation region 105 is, for example, a deep trench isolation (DTI) formed between the pixels 51.

The pixel separation region 105 reaches a middle portion from the light incident surface in the light receiving region 103 toward a surface facing the light incident surface in the light receiving region 103. The pixel separation region 105 is provided so as to partition, for each light receiving region 103, the pixel array 21 in which the plurality of light receiving regions 103 provided for each pixel 51 is arranged in a matrix.

As a result, each pixel 51 can confine the photoelectrically converted charges in the light receiving region 103 by the pixel separation region 105, so that it is possible to prevent occurrence of electrical color mixture due to leakage of the charges to the adjacent pixel 51. Next, a configuration example of the pixel separation region 103 will be described.

### [6. Configuration Example of Pixel Separation Region]

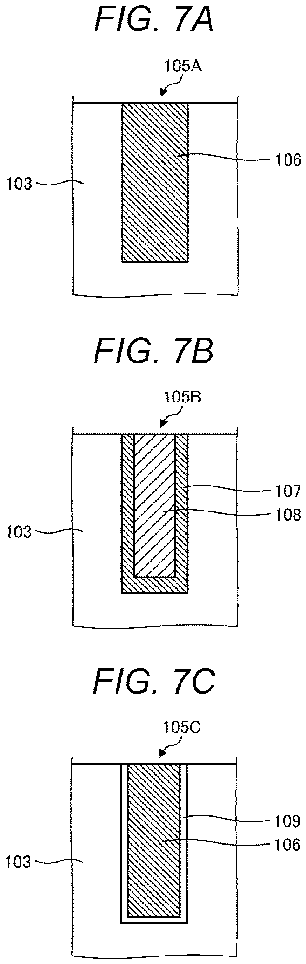

Figs. 7A to 7C are diagrams illustrating configuration examples of the pixel separation region according to the present disclosure. As illustrated in Fig. 7A, a pixel separation region 105A is constituted by an insulator 106 such as SiO₂, for example. As a result, in the pixel 51, as described above, electrical color mixture between the pixels 51 can be prevented by the pixel separation region 105A. Furthermore, according to the pixel separation region 105, by reflecting the light incident on the light receiving region 103, it is possible to prevent optical color mixture due to leakage of the incident light to the adjacent pixel 51.

Furthermore, as illustrated in Fig. 7B, a pixel separation region 105B may be constituted by a metal 108 having an insulating film 107 such as SiO₂ provided on the surface. According to the pixel separation region 105B, the metal 108 functions as a light shielding film, so that it is possible to prevent optical color mixture due to leakage of incident light to the adjacent pixel 51.

Furthermore, as illustrated in Fig. 7C, a pixel separation region 105C may be constituted by the insulator 106 such as SiO₂ in which a negative fixed charge film 109 is provided on the surface. According to the pixel separation region 105C, the negative high and low charge film 109 can reduce dark currents and white spots generated on the surface of the pixel separation region 105C while maintaining the electric field distribution of the light receiving region 103.

Furthermore, the pixel separation regions 105A, 105B, and 105C illustrated in Figs. 7A to 7C can be put into an electrically floating state. In this case, in the pixel 51, a current flowing from the signal retrieval portion 65 to the incident surface electrode 104 flows more uniformly in the light receiving region 103, so that a necessary electric field can be formed up to the vicinity of the incident surface electrode 104 even if the pixel 51 becomes finer.

Furthermore, a voltage equal to or lower than the ground potential may be applied to the metal 108 in the pixel separation region 105B and the negative fixed charge film 109 in the pixel separation region 105C. In this case, in the pixel 51, Si in the light receiving region 103 in the vicinity of the pixel separation regions 105B and 105C is pinned to P-type, so that dark currents and white spots generated on the surfaces of the pixel separation regions 105B and 105C can be reduced.

As described above, in the pixel 51, optical color mixture and electrical color mixture are prevented by the pixel separation regions 105A, 105B, and 105C, so that resolution of a luminance image and a distance image can be improved, and noise caused by the dark currents, and the like, can be reduced. Furthermore, in a case where background light is strong, sensitivity of the pixel 51 can be lowered by bringing a voltage to be applied to the incident surface electrode 104 close to 0 V.

### [7. Modifications of Pixel Separation Region]

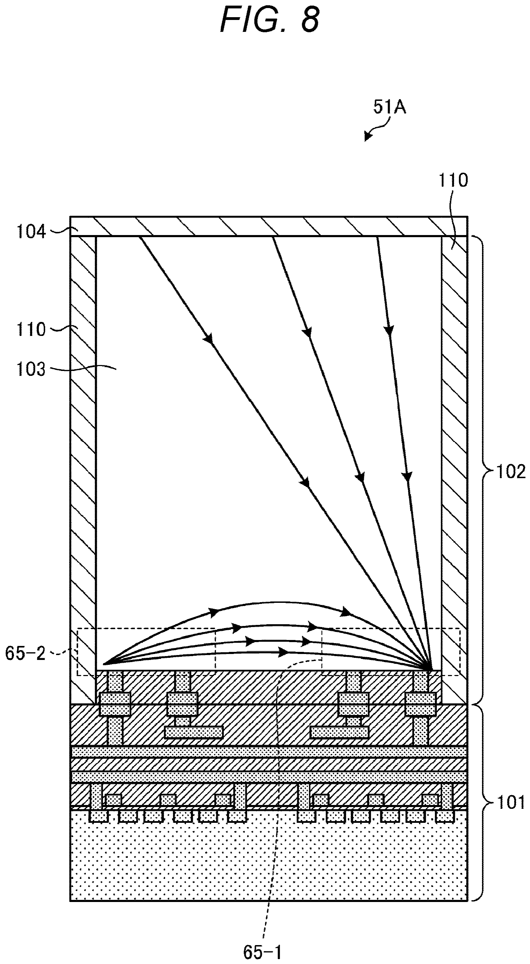

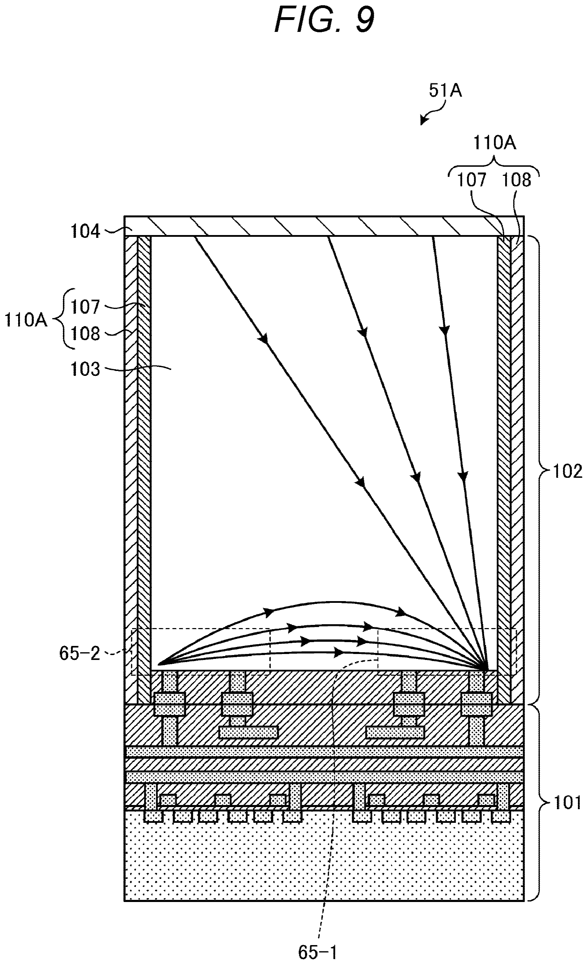

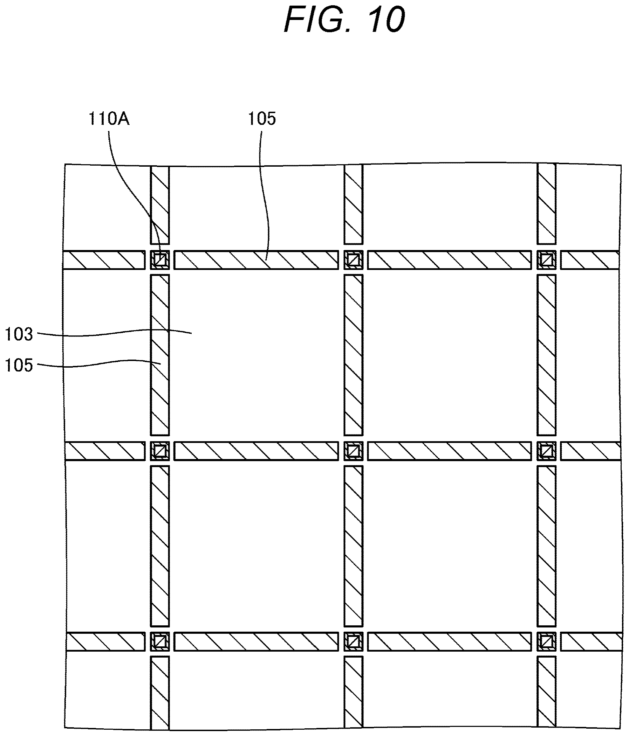

Next, modifications and arrangement examples of the pixel separation region will be described with reference to Figs. 8 to 10. Fig. 8 is an explanatory diagram of a pixel separation region according to a first modification of the present disclosure. Fig. 9 is an explanatory diagram of a pixel separation region according to a second modification of the present disclosure. Fig. 10 is a diagram illustrating an arrangement example of the pixel separation region according to the present disclosure.

As illustrated in Fig. 8, a pixel 51A according to the first modification includes a pixel separation region 110 that reaches a surface facing the incident surface of the light, of the sensor substrate 102 from the light incident surface of the light receiving region 103. The pixel separation region 110 is constituted by, for example, an insulator such as SiO₂. The pixel separation region 110 is provided so as to penetrate front and back surfaces of the sensor substrate 102, so that it is possible to more reliably prevent optical color mixture and electrical color mixture occurring between the adjacent pixels 51A.

Furthermore, as illustrated in Fig. 9, a pixel separation region 110A included in the pixel 51B according to the second modification is provided so as to penetrate front and back surfaces of the sensor substrate 102, but has a configuration different from that of the pixel separation region 110 illustrated in Fig. 8.

The pixel separation region 110A is constituted by a metal 108 having an insulating film 107 such as SiO₂ provided on the surface. For example, as illustrated in Fig. 10, the pixel separation region 110A is provided at corners of the plurality of light receiving regions 103 having a rectangular shape in planar view and arranged in a matrix and connects the incident surface electrode 104 and the ground wiring or the negative voltage generation circuit.

In the pixel separation region 110A, for example, a ground (ground) terminal of the sensor substrate 102 and each incident surface electrode 104 can be connected by a low-resistance wiring on a surface side facing the light incident surface in the light receiving region 103 or a low-resistance wiring on the circuit board 101. With this arrangement, the incident surface electrode 104 is prevented from voltage drop due to wiring resistance.

Furthermore, in a case where the pixel separation region 110A is provided at corner portions in the light receiving region 103 having a rectangular shape in planar view, for example, the pixel separation region 105 illustrated in Fig. 6 is provided on the outer periphery of the light receiving region 103 other than the corner portions in planar view.

Thus, in each light receiving region 103, most of the outer periphery other than the corners in the outer periphery in planar view is surrounded by the pixel separation region 105 extending from the light incident surface in the light receiving region 103 to a middle portion in a depth direction.

As a result, most of the current flowing from the signal retrieval portion 65 to the incident surface electrode 104 uniformly flows in the light receiving region 103, so that a necessary electric field can be formed up to the vicinity of the incident surface electrode 104 even if the pixel 51 becomes finer.

Note that the effects described in the present specification are merely examples and are not limited, and other effects may be provided.

Note that the present technology can also have the following configurations.
(1) A light receiving element including:
   a sensor substrate provided with:
      a light receiving region that photoelectrically converts incident light into signal charges;
      a pair of voltage application electrodes to which a voltage is alternately applied to generate in the light receiving region, an electric field that time-divides the signal charges and distributes the signal charges to a pair of charge accumulation electrodes; and
      an incident surface electrode which is provided on an incident surface of light in the light receiving region and to which a voltage equal to or lower than a ground potential is applied; and
   a circuit board provided with:
      a pixel transistor that is provided on a surface facing the incident surface of the light, of the sensor substrate and processes the signal charges accumulated in the charge accumulation electrodes.
(2) The light receiving element according to (1), in which
   the incident surface electrode is a hole accumulation layer formed on the incident surface by a negative fixed charge film laminated on the incident surface of the light.
(3) The light receiving element according to (1), in which
   the incident surface electrode is a P-type conductive layer in which the incident surface of the light is doped with a P-type impurity.
(4) The light receiving element according to (1), in which
   the incident surface electrode is an inorganic electrode film laminated on the incident surface of the light.
(5) The light receiving element according to (1), in which
   the incident surface electrode is a metal film having a film thickness having translucency and laminated on the incident surface of the light.
(6) The light receiving element according to any one of (1) to (6), further including:
   a pixel separation region provided between a plurality of the light receiving regions arranged in a matrix and electrically separating adjacent light receiving regions.
(7) The light receiving element according to (6), in which
   the pixel separation region reaches a middle portion from the incident surface of the light toward a surface facing the incident surface in the light receiving region.
(8) The light receiving element according to (7), in which the pixel separation region partitions a pixel array in which a plurality of the light receiving regions is arranged in a matrix, for each of the light receiving regions and is electrically floating.
(9) The light receiving element according to (6), in which
   the pixel separation region reaches a surface facing the incident surface, of the sensor substrate from the incident surface of the light.
(10) The light receiving element according to (9), in which
   the pixel separation region is provided at corner portions in a plurality of the light receiving regions having a rectangular shape in planar view arranged in a matrix and connects the incident surface electrode and a ground wiring or a negative voltage generation circuit.
(11) The light receiving element according to any one of (6) to (10), in which
   the pixel separation region is constituted by an insulator.
(12) The light receiving element according to any one of (6) to (10), in which
   the pixel separation region is constituted by a metal provided with an insulating film on a surface of the metal.
(13) The light receiving element according to any one of (6) to (10), in which
   the pixel separation region is constituted by an insulator provided with a negative fixed charge film on a surface of the insulator.
(14) An imaging element including:
   a sensor substrate provided with:
      a pixel array in which a plurality of light receiving regions that photoelectrically converts incident light into signal charges is arranged in a matrix;
      a pair of voltage application electrodes to which a voltage is alternately applied for each of the light receiving regions to generate, in each of the light receiving regions, an electric field that time-divides the signal charges and distributes the signal charges to a pair of charge accumulation electrodes; and
      an incident surface electrode which is provided on an incident surface of light in each of the light receiving regions and to which a voltage equal to or lower than a ground potential is applied; and
   a circuit board provided with:
      a pixel transistor that is provided on a surface facing the incident surface of the light, of the sensor substrate and processes the signal charges accumulated in the charge accumulation electrodes.
(15) An imaging device including:
   an imaging optical system;
   a sensor substrate provided with:
      a pixel array in which a plurality of light receiving regions that photoelectrically converts incident light into signal charges is arranged in a matrix;
      a pair of voltage application electrodes to which a voltage is alternately applied for each of the light receiving regions to generate, in each of the light receiving regions, an electric field that time-divides the signal charges and distributes the signal charges to a pair of charge accumulation electrodes; and
      an incident surface electrode which is provided on an incident surface of light in each of the light receiving regions and to which a voltage equal to or lower than a ground potential is applied; and
   a circuit board provided with: a pixel transistor that is provided on a surface facing the incident surface of the light, of the sensor substrate and processes the signal charges accumulated in the charge accumulation electrodes.

### REFERENCE SIGNS LIST

- 11: Solid-state imaging element
- 21: Pixel array unit
- 22: Vertical drive unit
- 51: Pixel
- 61: Substrate
- 62: On-chip lens
- 71-1, 71-2, 71: N+ semiconductor region
- 73-1, 73-2, 73: P+ semiconductor region
- 441-1, 441-2, 441: Separation region
- 471-1, 471-2, 471: Separation region
- 631: Reflecting member
- 721: Transfer transistor
- 722: FD
- 723: Reset transistor
- 724: Amplification transistor
- 725: Selection transistor

## Claims

1. A light receiving element comprising:
a sensor substrate provided with:
a light receiving region that photoelectrically converts incident light into signal charges;
a pair of voltage application electrodes to which a voltage is alternately applied to generate in the light receiving region, an electric field that time-divides the signal charges and distributes the signal charges to a pair of charge accumulation electrodes; and
an incident surface electrode which is provided on an incident surface of light in the light receiving region and to which a voltage equal to or lower than a ground potential is applied; and
a circuit board provided with:
a pixel transistor that is provided on a surface facing the incident surface of the light, of the sensor substrate and processes the signal charges accumulated in the charge accumulation electrodes.

2. The light receiving element according to claim 1,
wherein the incident surface electrode is a hole accumulation layer formed on the incident surface by a negative fixed charge film laminated on the incident surface of the light.

3. The light receiving element according to claim 1,
wherein the incident surface electrode is a P-type conductive layer in which the incident surface of the light is doped with a P-type impurity.

4. The light receiving element according to claim 1,
wherein the incident surface electrode is an inorganic electrode film laminated on the incident surface of the light.

5. The light receiving element according to claim 1,
wherein the incident surface electrode is a metal film having a film thickness having translucency and laminated on the incident surface of the light.

6. The light receiving element according to claim 1, further comprising:
a pixel separation region provided between a plurality of the light receiving regions arranged in a matrix and electrically separating adjacent light receiving regions.

7. The light receiving element according to claim 6,
wherein the pixel separation region reaches a middle portion from the incident surface of the light toward a surface facing the incident surface in the light receiving region.

8. The light receiving element according to claim 7,
wherein the pixel separation region partitions a pixel array in which a plurality of the light receiving regions is arranged in a matrix, for each of the light receiving regions and is electrically floating.

9. The light receiving element according to claim 6,
wherein the pixel separation region reaches a surface facing the incident surface, of the sensor substrate from the incident surface of the light.

10. The light receiving element according to claim 9,
wherein the pixel separation region is provided at corner portions in a plurality of the light receiving regions having a rectangular shape in planar view arranged in a matrix and connects the incident surface electrode and a ground wiring or a negative voltage generation circuit.

11. The light receiving element according to claim 6,
wherein the pixel separation region is constituted by an insulator.

12. The light receiving element according to claim 6,
wherein the pixel separation region is constituted by a metal provided with an insulating film on a surface of the metal.

13. The light receiving element according to claim 6,
wherein the pixel separation region is constituted by an insulator provided with a negative fixed charge film on a surface of the insulator.

14. An imaging element comprising:
a sensor substrate provided with:
a pixel array in which a plurality of light receiving regions that photoelectrically converts incident light into signal charges is arranged in a matrix;
a pair of voltage application electrodes to which a voltage is alternately applied for each of the light receiving regions to generate, in each of the light receiving regions, an electric field that time-divides the signal charges and distributes the signal charges to a pair of charge accumulation electrodes; and
an incident surface electrode which is provided on an incident surface of light in each of the light receiving regions and to which a voltage equal to or lower than a ground potential is applied; and
a circuit board provided with:
a pixel transistor that is provided on a surface facing the incident surface of the light, of the sensor substrate and processes the signal charges accumulated in the charge accumulation electrodes.

15. An imaging device comprising:
an imaging optical system;
a sensor substrate provided with:
a pixel array in which a plurality of light receiving regions that photoelectrically converts incident light into signal charges is arranged in a matrix;
a pair of voltage application electrodes to which a voltage is alternately applied for each of the light receiving regions to generate, in each of the light receiving regions, an electric field that time-divides the signal charges and distributes the signal charges to a pair of charge accumulation electrodes; and
an incident surface electrode which is provided on an incident surface of light in each of the light receiving regions and to which a voltage equal to or lower than a ground potential is applied; and
a circuit board provided with:
a pixel transistor that is provided on a surface facing the incident surface of the light, of the sensor substrate and processes the signal charges accumulated in the charge accumulation electrodes.
